(19) Europäisches Patentamt
European Patent Office
Office européen des brevets

(11) **EP 4 651 138 A2**

(12) **EUROPEAN PATENT APPLICATION**

(43) Date of publication:
**19.11.2025 Bulletin 2025/47**

(21) Application number: **24223663.6**

(22) Date of filing: **30.12.2024**

(51) International Patent Classification (IPC):
**G11C 13/00** (2006.01)     **G11C 16/34** (2006.01)

(52) Cooperative Patent Classification (CPC):
**G11C 13/0033; G11C 13/0035; G11C 16/3495;**
G06F 12/0238; G11C 13/0004

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **14.05.2024 KR 20240063333**

(71) Applicant: **SK Hynix Inc.**
**Icheon-si, Gyeonggi-do 17336 (KR)**

(72) Inventors:
• **NA, Myung Hee**
**17336 Icheon-si, Gyeonggi-do (KR)**
• **MOON, Tae Young**
**17336 Icheon-si, Gyeonggi-do (KR)**
• **SHIN, Young Kyun**
**17336 Icheon-si, Gyeonggi-do (KR)**
• **LEE, Seung Yun**
**17336 Icheon-si, Gyeonggi-do (KR)**
• **JOH, Jung Hyun**
**17336 Icheon-si, Gyeonggi-do (KR)**

(74) Representative: **Isarpatent**
**Patent- und Rechtsanwälte**
**Barth Hassa Peckmann & Partner mbB**
**Friedrichstraße 31**
**80801 München (DE)**

(54) **DATA STORAGE DEVICE AND METHOD OF OPERATING THE SAME**

(57)     A data storage device with improved lifespan according to the present technology may include a memory device including a plurality of memory cells disposed between word lines and bit lines, and a voltage generator configured to generate operation voltages and provide the operation voltages to the plurality of memory cells, and a controller configured to control the memory device to divide the plurality of memory cells into a plurality of groups according to a line resistance from the voltage generator to each of the plurality of memory cells, and store data in memory cells included in a selected group among the plurality of groups according to attribute of the data to be stored.

# FIG. 1

**Description**

**BACKGROUND**

1. Field of Invention

Embodiments of the present disclosure generally relate to a data storage device and a method of operating the same, and more particularly, to a data storage device with improved lifespan and a method of operating the same.

2. Description of Related Art

A memory device may include a volatile memory device in which stored data is lost when power supply is cut off, and a nonvolatile memory device in which stored data is maintained even though power supply is cut off. It may have a certain logic state according to a physical/chemical property of a material configuring the memory cells included in the memory device. A memory cell including a chalcogenide material may have a characteristic in which an operation speed is lower than that of a dynamic random access memory (DRAM), but a capacity (integration degree) that is greater than that of the DRAM. Further, the memory cell including a chalcogenide material has a capacity (integration degree) less than that of a NAND flash memory, but an operation speed is faster than that of the NAND flash memory.

**SUMMARY**

An embodiment of the present disclosure provides a memory device with improved lifespan and a method of operating the same.

According to an embodiment of the present disclosure, the data storage device comprises a memory device including a plurality of memory cells disposed between word lines and bit lines, and a voltage generator configured to generate operation voltages and provide the operation voltages to the plurality of memory cells; and a controller configured to control the memory device to: divide the plurality of memory cells into a plurality of groups according to a line resistance from the voltage generator to each of the plurality of memory cells, and store data in memory cells included in a selected group among the plurality of groups according to an attribute of the data to be stored.

According to an embodiment of the present disclosure, the controller includes a cell attribute information storage configured to store cell attribute information, which is information on a group to which each of the plurality of memory cells belong among the plurality of groups.

According to an embodiment of the present disclosure, the memory device comprises: a word line controller configured to provide, to the word lines, a word line voltage among the operation voltages and a bit line controller configured to provide, to the bit lines, a bit line voltage among the operation voltages.

According to an embodiment of the present disclosure, a value of the line resistance reaching each of the plurality of memory cells increases as a path length increases, and the path length is determined as a sum of a length of a metal line from the voltage generator of the memory device to the word line controller and the bit line controller, a length of a word line connected from the word line controller to each of the plurality of memory cells, and a length of a bit line connected from the bit line controller to each of the plurality of memory cells.

According to an embodiment of the present disclosure, the controller further comprises: an address allocator configured to allocate an address of memory cells selected to store the data according to the cell attribute information and the attribute of the data and an operation processor configured to provide the memory device with a command instructing to store the data in the selected memory cells.

According to an embodiment of the present disclosure, the plurality of groups include a first group, a second group, and a third group according to the line resistance.

According to an embodiment of the present disclosure, a line resistance of memory cells belonging to the second group is greater than a line resistance of memory cells belonging to the first group and less than a line resistance of memory cells belonging to the third group.

According to an embodiment of the present disclosure, the first group includes memory cells of which the line resistance belongs to a first range among the plurality of memory cells, the second group includes memory cells of which the line resistance belongs to a second range greater than the first range, among the plurality of memory cells, and the third group includes memory cells of which the line resistance belongs to a third range greater than the second range, among the plurality of memory cells.

According to an embodiment of the present disclosure, the address allocator allocates, for the data, an address of the memory cells belonging to the first group when the attribute of the data is cold data that is accessed relatively less frequently.

According to an embodiment of the present disclosure, the address allocator allocates, for the data, an address of memory cells belonging to the second group or the third group when the attribute of the data is hot data that is accessed relatively frequently.

According to an embodiment of the present disclosure, the address allocator allocates, for the data, an address of the memory cells belonging to the first group when the attribute of the data is firmware data of the memory device.

According to an embodiment of the present disclosure, the address allocator allocates, for the data, an address of the memory cells belonging to the second group or the third group when the attribute of the data is user data.

According to an embodiment of the present disclosure, the plurality of memory cells includes an amorphous chalcogenide-based material.

According to an embodiment of the present disclosure, the data storage device comprises a memory device including a plurality of groups each including a plurality of memory cells and a controller configured to control the memory device to: store wear-level information determined according to the number of times an access operation on each of the plurality of groups is performed, a type of the access operation, and an attribute of each of the plurality of groups, and perform a wear-leveling operation of moving data stored in memory cells belonging to a group selected based on the wear-level information, among the plurality of groups, to memory cells belonging to another group.

According to an embodiment of the present disclosure, the controller comprises: a wear-level manager configured to update wear-level information for a group in which memory cells on which the access operation is performed are included after an access operation is performed on the memory device and a wear-level information storage configured to store the wear-level information.

According to an embodiment of the present disclosure, the wear-level information includes wear-level information corresponding to each of the plurality of groups.

According to an embodiment of the present disclosure, the wear-level information includes bitmap data indicating whether wear-level information corresponding to each of the plurality of groups exceeds a reference value.

According to an embodiment of the present disclosure, the wear-level manager moves data stored in a group having wear-level information exceeding the reference value among the plurality of groups to another group, based on the bitmap data.

According to an embodiment of the present disclosure, wherein the wear-level manager swaps data stored in a group having wear-level information exceeding the reference value among the plurality of groups with data stored in a group having wear-level information less than or equal to the reference value, based on the bitmap data.

According to an embodiment of the present disclosure, the wear-level information storage stores information on an access type weight including a first access type weight corresponding to a write operation and a second access type weight corresponding to a read operation.

According to an embodiment of the present disclosure, the memory device comprises: a voltage generator configured to generate operation voltages and provide the operation voltages to the plurality of memory cells; a word line controller configured to provide, to the word lines, a word line voltage among the operation voltages and a bit line controller configured to provide, to the bit lines, a bit line voltage among the operation voltages, and wherein the plurality of groups are determined according to a line resistance from the voltage generator to each of the plurality of memory cells.

According to an embodiment of the present disclosure, a value of the line resistance reaching each of the plurality of memory cells increases as a path length increases, and the path length is determined as a sum of a length of a metal line from the voltage generator to the word line controller and the bit line controller, a length of a word line connected from the word line controller to each of the plurality of memory cells, and a length of a bit line connected from the bit line controller to each of the plurality of memory cells.

According to an embodiment of the present disclosure, the wear-level information storage stores information on a cell attribute weight for each of the plurality of groups determined according to the size of the line resistance.

According to an embodiment of the present disclosure, the information on the cell attribute weight includes a plurality of cell attribute weights increasing as the size of the line resistance decreases.

According to an embodiment of the present disclosure, the wear-level manager calculates the wear-level information by reflecting the access type weight and the cell attribute weight in the number of times the access operation is performed.

According to an embodiment of the present disclosure, the wear-level manager reflects the first access type weight in the number of times the access operation is performed when the access operation is a write operation, and reflects the second access type weight less than the first access type weight in the number of times the access operation is performed when the access operation is a read operation.

According to an embodiment of the present disclosure, the wear-level manager updates the wear-level information by accumulating calculated wear-level information on previously stored wear-level information.

According to an embodiment of the present disclosure, the plurality of memory cells include an amorphous chalcogenide-based material.

According to an embodiment of the present disclosure, the storage device comprising: a plurality of memory groups each including a plurality of memory cells and a controller configured to move data stored in memory cells included one group among the plurality of memory groups to memory cells included in another memory group based on wear-level information reflecting a type of an operation performed on the plurality of memory cells and a weight corresponding to each of the plurality of memory groups.

The present technology may provide a memory device with improved lifespan and a method of operating the same.

## BRIEF DESCRIPTION OF THE DRAWINGS

FIG. 1 is a diagram illustrating a data storage device including a memory device according to an embodiment of the present disclosure.

FIG. 2 is a diagram illustrating the memory device of FIG. 1 according to an embodiment of the present disclosure.

FIG. 3 is a diagram illustrating a voltage applied during a write operation and a read operation of the memory device according to an embodiment of the present disclosure.

FIG. 4 is a diagram illustrating an attribute of memory cells according to an embodiment of the present disclosure.

FIG. 5 is a diagram illustrating a reference for determining a group to which the memory cells belong according to a path length in accordance with an embodiment of the present disclosure.

FIG. 6 is a diagram illustrating a group to which the memory cells belong according to a size of a line resistance in accordance with an embodiment of the present disclosure.

FIG. 7 is a diagram illustrating a controller of FIG. 1 according to an embodiment of the present disclosure.

FIG. 8 is a diagram illustrating cell attribute information stored in cell attribute information storage of FIG. 7 according to an embodiment of the present disclosure.

FIG. 9 is a diagram illustrating the cell attribute information stored in the cell attribute information storage of FIG. 7 according to another embodiment of the present disclosure.

FIG. 10 is a flowchart illustrating an operation of a data storage device according to an embodiment of the present disclosure.

FIG. 11 is a diagram illustrating the controller of FIG. 7 according to another embodiment of the present disclosure.

FIG. 12 is a diagram illustrating wear-level information stored in wear-level information storage of FIG. 11 according to an embodiment of the present disclosure.

FIG. 13 is a diagram illustrating the wear-level information according to another embodiment of the present disclosure.

FIG. 14 is a diagram illustrating an access type weight according to an embodiment of the present disclosure.

FIG. 15 is a diagram illustrating a cell attribute weight according to an embodiment of the present disclosure.

FIG. 16 is a diagram illustrating the cell attribute weights according to another embodiment of the present disclosure.

FIG. 17 is a diagram illustrating a wear-leveling operation according to an embodiment of the present disclosure.

FIG. 18 is a diagram illustrating a wear-leveling operation according to another embodiment of the present disclosure.

FIG. 19 is a flowchart illustrating an operation of a data storage device according to another embodiment of the present disclosure.

FIG. 20 is a flowchart illustrating a method of updating wear-level information of FIG. 19 according to an embodiment of the present disclosure.

FIG. 21 is a diagram illustrating the controller of FIG. 1 according to still another embodiment of the present disclosure.

FIG. 22 is a block diagram illustrating a user system to which a data storage device according to an embodiment of the present disclosure is applied.

## DETAILED DESCRIPTION

Specific structural or functional descriptions of embodiments according to the concepts which are disclosed in the present specification are illustrated only to describe the embodiments according to the concept of the present disclosure. The embodiments according to the concept of the present disclosure may be carried out in various forms and are not limited to the embodiments described in the present specification.

Hereinafter, embodiments of the present disclosure are described with reference to the attached drawings in order to describe enough detail to enable those skilled in the art to practice the technical idea of the present disclosure.

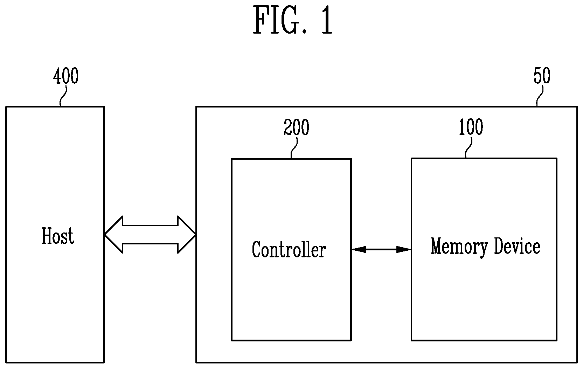

FIG. 1 is a diagram illustrating a data storage device including a memory device according to an embodiment of the present disclosure.

Referring to FIG. 1, the data storage device 50 may include a memory device 100 and a controller 200. The data storage device 50 may be a device that stores data under control of a host 400 such as a cellular phone, a smartphone, a laptop computer, a desktop computer, a game player, a smart TV, a tablet PC, or an in-vehicle infotainment system. In an embodiment, the data storage device 50 may be a device that receives control of the host 400 through wired or wireless communication storing data in a remote position, such as a server or a data center.

The data storage device 50 may interface with the host 400 through various communication methods, and the data storage device 50 may be configured of various devices according to an interfacing method. For example, the data storage device 50 may be configured of any of various types of storage devices such as a solid state drive (SSD), an embedded multi-media card (eMMC), a secure digital card in a form of an SD, a mini-SD and a micro-SD, a universal serial bus (USB) storage device, a universal flash storage (UFS) device, a personal computer memory card international association (PCMCIA) card type storage device, a peripheral component interconnection (PCI) card type storage device, a PCI express (PCI-e or PCIe) card type storage device, a compact flash (CF) card, and a smart media card.

In an embodiment, the data storage device 50 may be manufactured as any of various types of packages. For example, the data storage device 50 may be manufactured as any of various package types, such as a package on package (POP), a system in package (SIP), a system on chip (SOC), a multi-chip package (MCP), a chip on board (COB), a wafer-level fabricated package (WFP), and a wafer-level stack package (WSP).

The memory device 100 may store data. The memory device 100 may operate in response to control of the controller 200. The memory device 100 may include a plurality of memory cells storing data.

Each of the memory cells may be configured to store one data bit or a plurality of data bits.

The memory cells may be accessed in a predetermined size unit according to a type of the memory device. A unit in which the memory cells are accessed may vary for each operation. For example, a write operation of storing data in the memory cell, a read operation of sensing data stored in the memory cell, and an erase operation of erasing data stored in the memory cell may be accessed in different size units.

In an embodiment, the memory device 100 may be a double data rate synchronous dynamic random access memory (DDR SDRAM), a low power double data rate4 (LPDDR4) SDRAM, a graphics double data rate (GDDR) SDRAM, a low power DDR (LPDDR), a Rambus dynamic random access memory (RDRAM), a NAND flash memory, a vertical NAND flash memory, a NOR flash memory, a resistive random access memory (RRAM), a phase-change memory (PCM), a magnetoresistive random access memory (MRAM), a ferroelectric random access memory (FRAM), or a spin transfer torque random access memory (STT-RAM).

Generally, the memory cells included in the memory device 100 form an array and are configured of a memory cell that stores data and a selector that selects the memory cell.

In a DRAM, a capacitor serves as the memory cell, and a transistor serves as the selector. In a case of a NAND flash memory device, a transistor serves as the selector for selecting the memory cell of a string unit.

The memory device 100 according to an embodiment of the present disclosure may include single cells including a chalcogenide-based material and two electrodes. In an embodiment, the chalcogenide-based material of the memory device 100 may be referred to as a dual function material (DFM). The DFM may have a threshold voltage like ovonic threshold switching (OTS), which serves as the selector in a phase-change memory (PCM).

The DFM is different from OTS, of which a threshold voltage does not change, and the threshold voltage may change during a bidirectional write operation. This change may be used as the memory cell, and thus the DFM may serve as both the memory cell and the selector through the bidirectional write operation. A memory device using the DFM may be a selector-only memory (SOM) device or a self-selecting memory (SSM) device.

In the present specification, the embodiments are described based on that the memory device 100 is a type of phase change memory including a SOM cell, which is a memory cell including a chalcogenide-based material.

The memory device 100 may be configured to receive a command and an address from the controller 200 and access a region selected by an address in the memory cell array. The memory device 100 may perform an operation instructed by the command on the region selected by the address. For example, the memory device 100 may perform a write operation (program operation), a read operation, and an erase operation. During the program operation, the memory device 100 may write data in the region selected by the address. During the read operation, the memory device 100 may read data from the region selected by the address. During the erase operation, the memory device 100 may erase data stored in the region selected by the address.

The controller 200 may control an overall operation of the data storage device 50.

When power is applied to the data storage device 50, the controller 200 may execute firmware (FW). The data storage device 50 may convert a logical address provided by the host 400 into a physical address used by the memory device 100.

The controller 200 may control the memory device 100 to perform the write operation, the read operation, the erase operation, or the like according to a request of the host 400. During the write operation, the controller 200 may provide a write command, an address, and data to the memory device 100. During the read operation, the controller 200 may provide a read command and an address to the memory device 100. During the erase operation, the controller 200 may provide an erase command and an address to the memory device 100.

The memory cells included in the memory device 100 may have a cycle endurance characteristic. The cycle endurance characteristic may be a phenomenon in which fail occurs when the write operation of storing data in the memory cell or the read operation of reading stored data is performed a certain level or more. A main cause of the cycle endurance characteristic may be one type of spike current that occurs during a turn-on process of the memory cell. The spike current may occur less as a line resistance of the memory cell increases. That is, the memory cell may show different cycle endurance characteristics according to a size of the line resistance of each memory cell, which indicates that lifespan of each of the memory cells may be different from each other.

When the memory cells are used without considering the cycle endurance characteristic, lifespan of the memory device 100 may be determined based on a memory cell with the worst cycle endurance characteristic.

In general, as a line resistance of the memory cell increases, the cycle endurance characteristic may be relatively good. This is because as the line resistance increases, an occurrence frequency of the spike current decreases. Therefore, storing data in consideration of the cycle endurance characteristic is required.

In an embodiment, the controller 200 may allocate an address according to an attribute of data to be stored. Data to be stored in the memory device 100 may be divided into various attributes. For example, the data may be firmware (FW) data of the controller 200. Alternatively, the data may be user data stored in the memory device 100 according to a request of the host 400. The firmware (FW) data may be data that is not corrected and only a read operation thereof is performed unless a special circumstance exists. However, the user data may be updated or corrected according to a user's need, and a frequency of update or correction may be significantly higher than that of the firmware (FW) data.

In various embodiments, data may be divided into hot data or cold data. The hot data may be data that is accessed relatively more than the cold data. Here, access may mean that the write operation is performed due to a need of update or correction of data, or the read operation is performed to use data.

According to an embodiment, the controller 200 may allocate an address indicating a position where data is to be stored in the memory device 100 in consideration of the attribute of the data. That is, data that is accessed relatively more may be stored in memory cells with a relatively long lifespan (that is, memory cells with a relatively good cycle endurance characteristic), whereas data that is accessed relatively little may be stored in memory cells with a short lifespan (that is, memory cells with a relatively weak cycle endurance characteristic).

In an embodiment, the controller 200 may independently generate a command, an address, and data and transmit, to the memory device 100, the command, the address, and the data, regardless of the request of the host 400. For example, the controller 200 may control the memory device 100 to perform various background operations for maintaining performance of the memory device 100. In an embodiment, the controller 200 may control the memory device to perform a wear-leveling operation of transmitting data stored in a memory cell of which a cycle endurance characteristic is weak to a memory cell of which a cycle endurance characteristic is not weak, by using a difference in lifespan by memory cells having different cycle endurance characteristics.

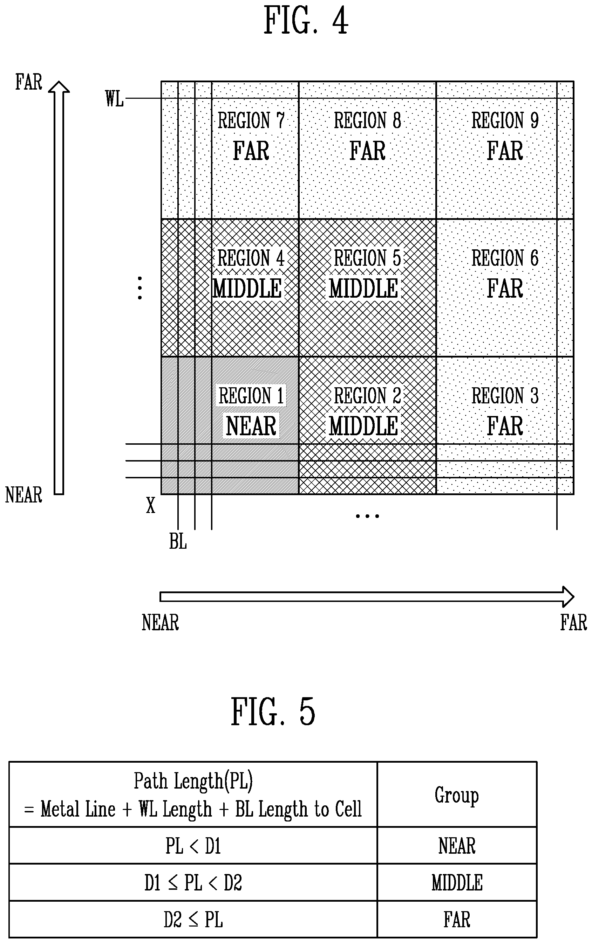

Address allocation and wear-leveling are described in more detail with reference to FIGS. 4 to 20 described later.

In an embodiment, the controller 200 may include an error correction code (ECC) processor. Alternatively, the ECC processor may be included in the data storage device 50 as a chip or a device separated from the controller 200. The ECC processor may detect and correct errors included in data obtained through the read operation from the memory device 100. In an embodiment, the number of bits that may be corrected by the ECC processor may be limited.

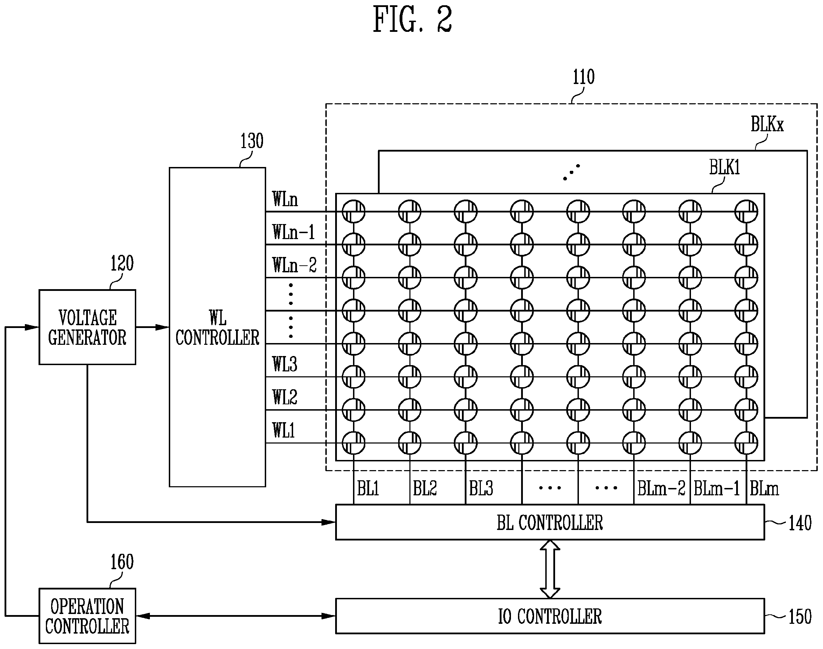

FIG. 2 is a diagram illustrating the memory device 100 of FIG. 1 according to an embodiment of the present disclosure.

Referring to FIG. 2, the memory device 100 may include a memory cell array 110, a voltage generator 120, a word line (WL) controller 130, a bit line (BL) controller 140, an input and output (input/output, IO) controller 150, and an operation controller 160.

The memory cell array 110 may include memory cells disposed at a point where a plurality of word lines WL1 to WLn and a plurality of bit lines BL1 to BLm cross.

In an embodiment, the memory cell array 110 may include a plurality of memory blocks BLK1 to BLKx. The memory block may be a unit that is driven together structurally or electrically. Each memory cell included in the memory cell array 110 may be connected to one word line and one bit line. In embodiments, the memory cell may include a chalcogenide-based dual function material (DFM). The memory cell may store a logic state according to a physical/chemical property or attribute of the DFM.

In some embodiments, the memory cell may be a SOM cell or a self-selecting memory (SSM) cell.

The memory cell may be in one of a set state or a reset state. The set state and the reset state may have opposite polarities.

In an embodiment, the set state may indicate logic "0" and the reset state may indicate logic "1". Alternatively, conversely, the set state may indicate logic "1" and the reset state may indicate logic "0".

The logic state of the memory cell may be detected by the read operation. The logic state of the memory cell may be based on a polarity of a voltage applied to the DFM configuring the memory cell. In an embodiment, the logic state of the memory cell may be at least partially based on a direction of a current applied to the memory cell or a polarity of an applied voltage during the write operation.

In this specification, for convenience of description, the set state is defined as a logic "1" state storing data "1", and the reset state is defined as a logic "0" state storing data "0".

In an embodiment, the memory cell in the set state may have a threshold voltage relatively higher than that of the memory cell in the reset state.

The voltage generator 120 may generate voltages necessary for an operation of the memory device 100. The voltage generator 120 may generate voltages in response to control of the operation controller 160 and provide the voltages to the word line controller 130 and the bit line controller 140. The voltage generator 120 may receive a power voltage from an outside and generate a necessary voltage by distributing or pumping the power voltage. In an embodiment, the voltage generator 120 may further include a pumping circuit that pumps a voltage in response to a clock signal.

The word line controller 130 may provide a word line voltage to the memory cells through the plurality of word lines WL1 to WLn respectively connected to the memory cells included in the memory cell array 110.

The bit line controller 140 may provide a bit line voltage to the memory cells through the plurality of bit lines BL1 to BLm respectively connected to the memory cells included in the memory cell array 110.

In an embodiment, the bit line controller 140 may include a sense amplifier (not shown) that senses data stored in the memory cells through the bit lines. In addition, the bit line controller 140 may include latches that store sensed data.

The input/output controller 150 may communicate data with the controller 200 described with reference to FIG. 1. Specifically, the input/output controller 150 may receive, from the controller 200, a command, an address, or data, and may transmit, to the controller 200, data stored in the memory cells or an internal register.

The operation controller 160 may control the word line controller 130 and the bit line controller 140 so that an operation on the memory cell array may be performed. Under control of the operation controller 160, each of the word line controller 130 and the bit line controller 140 may provide a voltage to the memory cell array.

Since the memory cells included in the memory cell array 110 have a two-dimensionally or three-dimensionally arranged structure, the memory cells may have different line resistances, respectively. The line resistance of each of the memory cells for the voltage generated by the voltage generator 120 is related to a path length corresponding to each of the memory cells. Specifically, the path length may be a sum of a length of a metal line from the voltage generator 120 to the word line controller 130 and the bit line controller 140, a length of the word line from the word line controller 130 to each memory cell, and a length of the bit line from the bit line controller 140 to each memory cell. Since the path lengths of each memory cell are different from each other, the line resistances of each memory cell may be different. In general, as the line resistance increases, a frequency of the spike current that occurs when the memory cell is turned on significantly decreases. Therefore, in terms of the cycle endurance characteristic, the lifespans of the memory cells may be different from each other due to a difference in line resistances (due to a difference in path lengths).

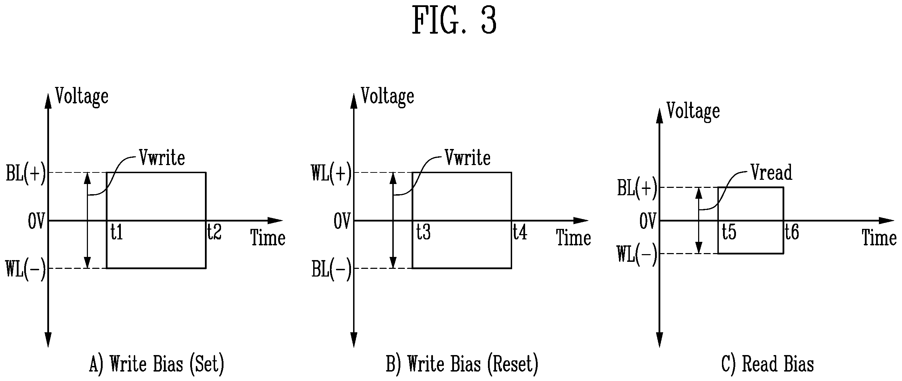

FIG. 3 is a diagram illustrating a voltage applied during the write operation and the read operation of the memory device according to an embodiment of the present disclosure.

Referring to FIG. 3, A) illustrates a voltage applied to the word line and the bit line connected to the memory cell during the write operation for writing the set state. B) illustrates the voltage applied to the word line and the bit line connected to the memory cell during the write operation for writing the reset state. C) illustrates the voltage applied to the word line and the bit line connected to the memory cell during the read operation of sensing a write state of the memory cell, namely, reading data stored in the memory cell.

In order to write the set state to the memory cell (that is, in order to write data "1"), the operation controller 160 described with reference to FIG. 2 may control each of the bit line controller 140 and the word line controller 130 so that a positive voltage is applied to the bit line and a negative voltage is applied to the word line in a period t1 to t2. At this time, a potential between the bit line and the word line may be a write voltage Vwrite. The write voltage Vwrite may have a voltage level that may turn on the memory cell.

In order to write the reset state to the memory cell (that is, in order to write data "0"), the operation controller 160 described with reference to FIG. 2 may control each of the bit line controller 140 and the word line controller 130 so that a negative voltage is applied to the bit line and a positive voltage is applied to the word line in a period t3 to t4. At this time, the potential between the bit line and the word line may be the write voltage Vwrite. The write voltage Vwrite may have a voltage level that may turn on the memory cell.

In an embodiment, the voltage applied to the word line and the bit line to write the set state to the memory cell and the voltage applied to the word line and the bit line to write the reset state to the memory cell may have the same size and opposite polarities.

During the read operation, the operation controller 160 described with reference to FIG. 2 may apply the same voltage regardless of the logic state of the memory cell. Specifically, the operation controller 160 may control each of the bit line controller 140 and the word line controller 130 so that a negative voltage is applied to the word line and a positive voltage is applied to the bit line in a period t5 to t6. A read voltage Vread which is a voltage applied during the read operation may have a voltage level lower than that of the write voltage Vwrite. Table 1 below shows a polarity of the read voltage Vread applied according to the read operation and a sensing result according to the logic state of the memory cell.

Table 1

| Memory cell logic state | Bit line voltage | Word line voltage | Sensing result |
|---|---|---|---|
| Set state | + | - | On cell |
| Reset state | | | Off cell |

After the read voltage is applied, the sense amplifier included in the bit line controller 140 may sense the state of the memory cell. When the memory cell is in the set state, a sensing result of the memory cell may be sensed as an on cell as a result of performing the read operation. The memory cell that is the on cell may indicate that the memory cell is turned on according to the read voltage, and may be divided into the logic "1" state. When the memory cell is in the reset state, a sensing result of the memory cell may be sensed as an off cell as a result of performing the read operation. The memory cell that is the off cell may indicate that the memory cell is turned off according to the read voltage and may be divided into the logic "0" state.

FIG. 4 is a diagram illustrating an attribute of the memory cells according to an embodiment of the present disclosure.

FIG. 5 is a diagram illustrating a reference for determining a group to which the memory cells belong according to the path length according to an embodiment of the present disclosure.

Referring to FIGS. 4 and 5, the memory cells may be formed in an array form disposed at a point where the word lines and the bit lines cross. As described with reference to FIG. 2, since the memory cells included in the memory cell array 110 have a two-dimensionally or three-dimensionally arranged structure, the memory cells may have different path lengths, respectively. In the illustrate example of FIG. 2, the path length of the memory cells may be a sum of a length of a metal line from the voltage generator 120 to the word line controller 130 and the bit line controller 140, a length of the word line from the word line controller 130 to each memory cell, and a length of the bit line from the bit line controller 140 to each memory cell.

In an embodiment, the memory cells may be divided into a plurality of groups or a plurality of regions according to the path length. For example, memory cells with a path length shorter than D1 are generally close to the word line controller 130 and the bit line controller 140, and thus may be determined as a near group. Memory cells with a path length greater than or equal to D1 and shorter than D2 may be determined as a middle group. Memory cells with a path length greater than or equal to D2 may be determined as a far group.

In FIG. 4, a first region may be determined as the near group. A second region, a fourth region, and a fifth region may be determined as the middle group. A third region and sixth to ninth regions may be determined as the far group. Since a cycle endurance characteristic of the memory cells belonging to the near group may be weaker than that of the memory cells belonging to the middle group or the far group, a lifespan of the memory cells belonging to the near group may be shorter than that of the memory cells belonging to the middle group or the far group. The lifespan of the memory cells belonging to the middle group may be longer than that of the memory cells belonging to the near group, but may be relatively shorter than that of the memory cells belonging to the far group. The memory cells belonging to the far group may have the lifespan longer than that of the memory cells included in the middle group and the near group.

In another embodiment of the present disclosure, the memory cells may be divided into a plurality of groups according to a size of the line resistance. That is, the memory cells may be divided into a first group, a second group, and a third group.

As the path length of the memory cell is decreased, the size of the line resistance may be decreased. Conversely, the path length of the memory cell is increased, the size of the line resistance may be increased. When the line resistance is small, an occurrence frequency of the spike current may relatively increase. When the line resistance is large, the occurrence frequency of the spike current may relatively decrease. Therefore, when the size of the line resistance is small, the cycle endurance characteristic may be relatively weak.

Therefore, the size of the line resistance of the memory cells belonging to the first group may be less than that of the memory cells belonging to the second group. The size of the line resistance of the memory cells belonging to the second group may be less than that of the memory cells belonging to the third group.

Since the cycle endurance characteristic of the memory cells belonging to the first group is weaker than that of the memory cells belonging to the second group or the third group, the lifespan of the memory cells belonging to the first group may be shorter than that of the memory cells belonging to the second group or the third group. The lifespan of the memory cells belonging to the second group may be longer than that of the memory cells belonging to the first group, but may be relatively shorter than that of the memory cells belonging to the third group. The memory cells belonging to the third group may have the lifespan longer than that of the memory cells included in the second group and the first group.

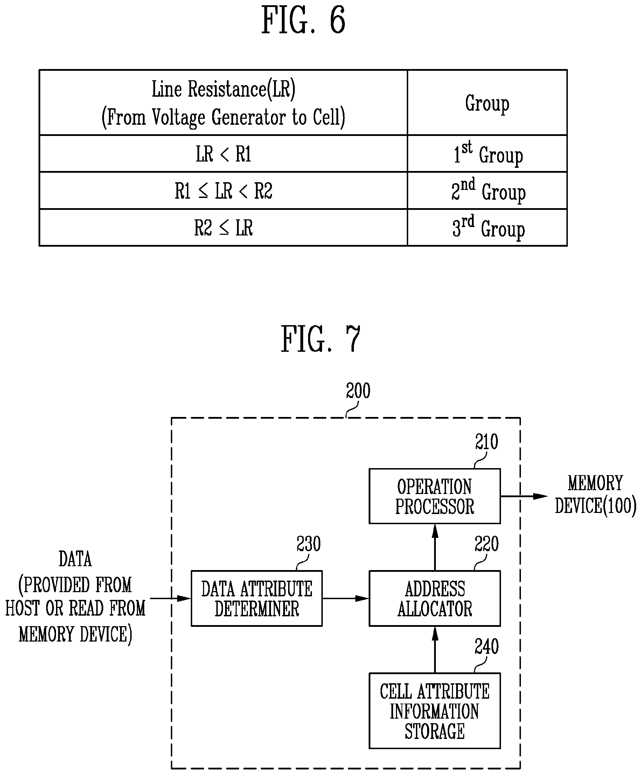

FIG. 6 is a diagram illustrating a group to which the memory cells belong according to the size of the line resistance in accordance with an embodiment of the present disclosure.

Referring to FIG. 6, the memory cells may be divided into a plurality of groups or a plurality of regions according to the size of the line resistance (LR).

Here, the line resistance may refer to a resistance of a path from the voltage generator 120 described with reference to FIG. 2 to each memory cell.

Memory cells with a line resistance less than R1 may be determined as the first group, and memory cells with a line resistance greater than or equal to R1 and less than R2 may be determined as the second group. Memory cells with a line resistance greater than or equal to R2 may be determined as the third group.

FIG. 7 is a diagram illustrating the controller 200 of FIG. 1 according to an embodiment of the present disclosure.

Referring to FIG. 7, the controller 200 may include an operation processor 210, an address allocator 220, a data attribute determiner 230, and a cell attribute information storage 240.

The operation processor 210 may control an overall operation of the controller 200. The operation processor 210 may receive an address allocated from the address allocator 220. The operation processor 210 may generate a command instructing an operation to be performed by the memory device 100 and provide the generated command and the address to the memory device 100.

In an embodiment, when the operation to be performed by the memory device 100 is the write operation, the operation processor 210 may provide a command, an address, and data to the memory device 100. When the operation to be performed by the memory device 100 is the read operation, the operation processor 210 may provide a command and an address to the memory device 100.

The address allocator 220 may allocate an address of the memory cells in the memory device 100 to be accessed. Specifically, during the write operation, the address allocator 220 may allocate an address indicating an address of memory cells in which data is to be stored and provide the allocated address to the operation processor 210. During the read operation, the address allocator 220 may provide an address indicating an address of memory cells on which the read operation is to be performed to the operation processor 210.

The data attribute determiner 230 may determine an attribute of data to be stored and provide the determined attribute of data to the address allocator 220. Specifically, the data to be stored in the memory device 100 may be data provided from the host or may be data read from the memory device 100. The data attribute determiner 230 may determine and assign the attribute of the data to be stored based on various references. In an embodiment, the attribute of the data to be stored may be one of hot data or cold data. The hot data may be data that is accessed more frequently than the cold data. Here, access may mean updating, changing, storing data, or reading stored data.

In various embodiments, the attribute of data may be one of firmware data or user data. The firmware data may be data that is not frequently updated or changed. Conversely, the user data may be data on which the write operation or the read operation is performed more frequently than the firmware data by updating or changing data through the host according to a user's need.

The cell attribute information storage 240 may store information on an attribute of the memory cells included in the memory device 100. The cell attribute information storage 240 may include information on a group to which the memory cells belong. In an embodiment, the group to which the memory cells belong may be one of the near group, the middle group, or the far group.

In various embodiments, the group to which the memory cells belong may be one of the first group, the second group, or the third group divided according to the size of the line resistance of each of the memory cells.

The address allocator 220 may allocate an address based on the attribute of the data provided from the data attribute determiner 230 and the cell attribute information stored in the cell attribute information storage. For example, when the attribute of the data to be stored is the cold data, an address of the memory cells belonging to the near group (or the first group) with a relatively weak cycle endurance characteristic may be allocated. Conversely, when the attribute of the data to be stored is the hot data, an address of the memory cells belonging to the middle group (or the second group) or the far group (or the third group) with a relatively good cycle endurance characteristic may be allocated.

In an embodiment, when the data to be stored is the firmware data, the address allocator 220 may allocate an address of the memory cells belonging to the near group (first group). Conversely, when the data to be stored is the user data, an address of the memory cells belonging to the middle group (second group) or the far group (third group) may be allocated.

According to an embodiment, the controller 200 may allocate an address in consideration of the attribute of the data to be stored and the lifespan of the memory cells included in the memory device 100. Through this, the controller 200 may control the memory device 100 so that the memory device 100 may be used for as long as possible.

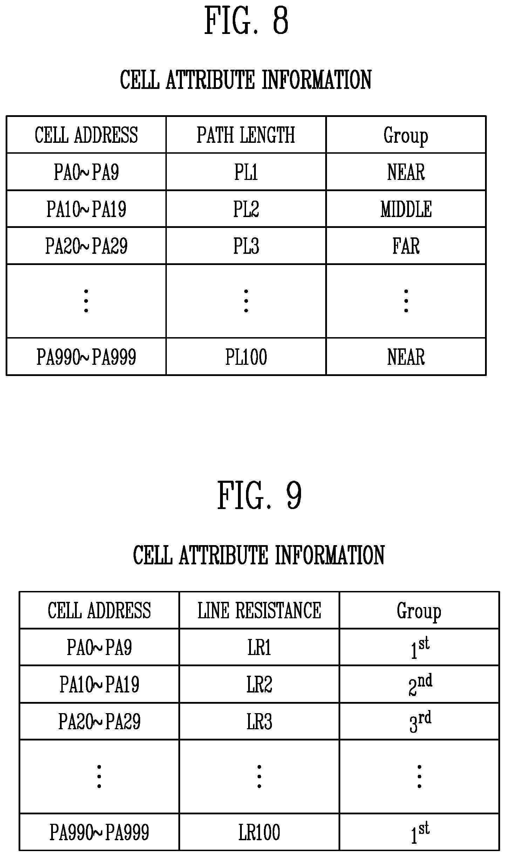

FIG. 8 is a diagram illustrating the cell attribute information stored in the cell attribute information storage 240 of FIG. 7 according to an embodiment of the present disclosure.

Referring to FIG. 8, the cell attribute information may include the physical address of the memory cells, the path length, and the information on the group to which the memory cells belong.

For example, memory cells corresponding to 0-th to ninth physical addresses PA0-PA9 may have a first path length PL1, and the first path length PL1 may be a value less than D1 described with reference to FIG. 5. In this case, an attribute of the memory cells corresponding to the 0-th to ninth physical addresses PA0-PA9 may be the near group.

Memory cells corresponding to the tenth to nineteenth physical addresses PA10-PA19 may have a second path length PL2, and the second path length PL2 may be a value greater than or equal to D1 and less than D2 described with reference to FIG. 5. In this case, an attribute of the memory cells corresponding to the tenth to nineteenth physical addresses PA10-PA19 may be the middle group.

Memory cells corresponding to twentieth to twenty-ninth physical addresses PA20-PA29 may have a third path length PL3, and the third path length PL3 may be greater than or equal to D2 described with reference to FIG. 5. In this case, an attribute of the memory cells corresponding to the twentieth to twenty-ninth physical addresses PA20-PA29 may be the far group.

In FIG. 8, the physical addresses of the memory cells are divided into 10 each, but this is only for convenience of description and does not limit the embodiment. In various embodiments, the cell attribute information for 10 or less or 10 or more physical addresses of the memory cells may be managed.

FIG. 9 is a diagram illustrating the cell attribute information stored in the cell attribute information storage of FIG. 7 according to another embodiment of the present disclosure.

Referring to FIG. 9, the cell attribute information may include the physical address of the memory cells, the line resistance, and the information on the group to which the memory cells belong. In FIG. 9, LR1 may be less than LR2, and LR2 may be less than LR3.

For example, memory cells corresponding to 0-th to ninth physical addresses PA0-PA9 may have a first line resistance LR1, and the first line resistance LR1 may be a value less than R1 described with reference to FIG. 6. In this case, an attribute of the memory cells corresponding to the 0-th to ninth physical addresses PA0-PA9 may be the first group.

Memory cells corresponding to the tenth to nineteenth physical addresses PA10-PA19 may have a second line resistance LR2, and the second line resistance LR2 may be a value greater than or equal to R1 and less than R2 described with reference to FIG. 6. In this case, an attribute of the memory cells corresponding to the tenth to nineteenth physical addresses PA10-PA19 may be the second group.

Memory cells corresponding to the twentieth to twenty-ninth physical addresses PA20-PA29 may have a third line resistance LR3, and the third line resistance LR3 may be a value greater than or equal to R2 described with reference to FIG. 6. In this case, an attribute of the memory cells corresponding to the twentieth to twenty-ninth physical addresses PA20-PA29 may be the third group.

In FIG. 9, the physical addresses of the memory cells are divided into 10 each, but this is only for convenience of description and does not limit the embodiment. In various embodiments, the cell attribute information for 10 or less or 10 or more physical addresses of the memory cells may be managed.

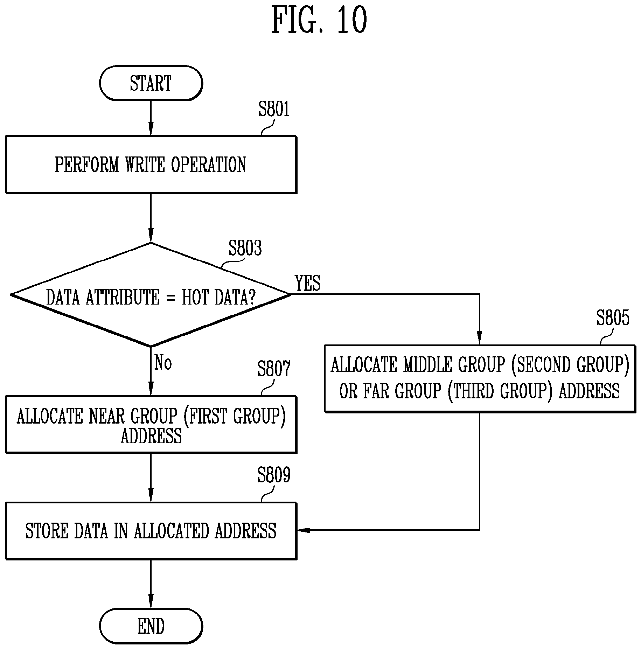

FIG. 10 is a flowchart illustrating an operation of a data storage device according to an embodiment of the present disclosure.

Referring to FIG. 10, in S801, the write operation of storing data in the data storage device is performed.

In S803, the data storage device may determine whether the attribute of the data to be stored is the hot data. When it is determined that the attribute of the data to be stored is the hot data (S803, YES), the operation proceeds to S805. When it is determined that the attribute of the data to be stored is the cold data (S803, NO), the operation proceeds to S807.

In S805, the data storage device may allocate the address of the memory cells belonging to the middle group (second group) or the far group (third group) to store the hot data.

In S807, the data storage device may allocate the address of the memory cells belonging to the near group (first group) to store the cold data.

In S809, the data storage device may store the data at the allocated address.

As described above, the memory cells included in the memory device have different cycle endurance characteristics due to a difference of the path length, and thus each memory cell may have different lifespans that may withstand repeated read operations and write operations. The lifespan of the memory device 100 may be maximized by dividing the memory cells into the near group, the middle group, and the far group according to the path length or dividing the memory cells into the first group, the second group, and the third group according to the size of the line resistance and managing the address by considering the attribute of the data to be stored.

However, even in this case, when access to a specific region is repeated according to a workload, a limitation in maximizing the lifespan of the memory device may exist. For example, even though the hot data is stored in the memory cells belonging to the far group (or the third group), when access occurs intensively only to memory cells of a specific region, as a result, the life of the memory device follows a lifespan of a region where a cycle endurance fail occurs the fastest.

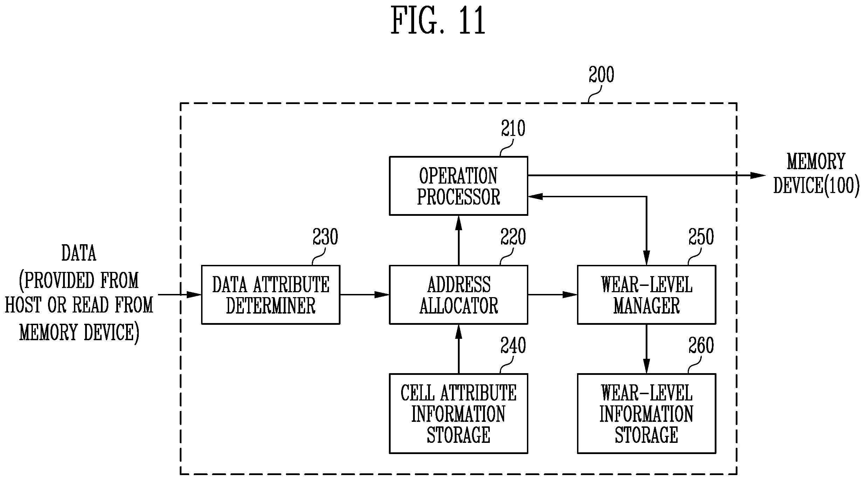

According to an embodiment of FIGS. 11 to 20 to be described later, the data storage device may maximize the lifespan of the memory device by dividing the memory cells into a plurality of groups and performing a wear-leveling operation of managing a wear-level of each group to increase similarly.

FIG. 11 is a diagram illustrating the controller 200 of FIG. 7 according to another embodiment of the present disclosure.

Referring to FIG. 11, the controller 200 may further include a wear-level manager 250 and a wear-level information storage 260 in addition to an operation processor 210, an address allocator 220, a data attribute determiner 230, and a cell attribute information storage 240.

Since an operation of the operation processor 210, the address allocator 220, the data attribute determiner 230, and the cell attribute information storage 240 is mostly the same as the embodiment of FIG. 7, only a portion which is different from the embodiment of FIG. 7 is described below.

The operation processor 210 may process an access operation on the memory device 100. Here, the access operation may include the write operation of storing data in the memory device 100 and the read operation of reading data from the memory device 100.

When the operation processor 210 processes the access operation, the operation processor 210 may provide the wear-level manager 250 with information on an address of a memory cell on which the access operation is performed and a type of the access operation.

The wear-level manager 250 may manage the wear-level of the memory device 100. Specifically, the wear-level manager 250 may store wear-level information of the memory cells included in the memory device 100. The wear-level manager 250 may cumulatively update the wear-level information each time the access operation on the memory device 100 is performed.

In an embodiment, the wear-level manager 250 may generate the wear-level information by firstly reflecting an access type weight and secondly reflecting a cell attribute weight for the number of times the access operation is performed. The access type weight is a weight according to a type of the access operation. The cell attribute weight is a weight according to an attribute of the memory cell on which the access operation is performed. A method of generating the wear-level information by the wear-level manager 250 is expressed mathematically as follows Equation 1.

## Equation 1

$$\textit{WEAR-LEVEL INFO(WLi)} = ACCESS\ COUNT(AC) \times ACCESS\ TYPE\ WEIGHT(AW) \times CELL\ ATTRIBUTE\ WEIGHT(CAW)$$

According to [Equation 1], the wear-level information may be a value obtained by multiplying an access count AC by an access type weight AW and multiplying by a cell attribute weight CAW. The access count AC is the number of times the access operation is performed. The access type weight AW is a weight according to a type of the access operation. The cell attribute weight CAW is a weight according to a cell attribute of the memory cell.

Specifically, the SOM cell may have different stress levels of the write operation and the read operation. For example, the stress level of a case where the read operation is performed may be about 10% compared to the stress level of a case where the write operation is performed. That is, the stress levels according to a type of the access operation may be different such as a stress level of a case where the write operation is performed once is similar to that of a case where the read operation is performed 8 to 9 times. Therefore, in order to manage the wear-level of the SOM memory device, reflecting the weight according to the type of the access operation is required rather than simply counting the number of times the access operation is performed.

As described with reference to FIG. 4, the memory cells may have different cycle endurance characteristics due to the differences in the path length, and thus each memory cell may have different lifespans that may withstand repeated read operations and write operations. Therefore, even in a case of managing the wear-level, it is necessary to divide the memory cells into a plurality of groups according to the path length and reflect the cell attribute weight which is an attribute according to the path length of the memory cells.

In the present embodiment, accurate management of wear-level may be possible by reflecting the weight according to the type of the access operation and the cell attribute weight according to the path length or the line resistance of the memory cells targeted for the access operation, rather than simply managing the number of access operations.

The wear-level information storage 260 may store the wear-level information generated by the wear-level manager 250. The wear-level manager 250 may generate the wear-level information each time the access operation is performed. The wear-level manager 250 may update the wear-level information with a value obtained by adding the generated wear-level information and existing wear-level information previously stored in the wear-level information storage 260.

In an embodiment, the wear-level information may be managed in a bitmap data form indicating whether the wear-level information exceeds a reference value. When storing and managing wear-level information on all memory cells, a large amount of memory capacity may be required. However, when the wear-level information is calculated and storing whether wear-level information exceeding the reference value exists in a bitmap form, an amount of data to be stored may be reduced.

In an embodiment, the wear-level manager 250 may perform the wear-leveling operation when the wear-level information exceeding the reference value is generated. Specifically, the wear-level manager 250 may control the memory device 100 to perform the wear-leveling operation through the operation processor 210 when the wear-level information exceeding the reference value is generated.

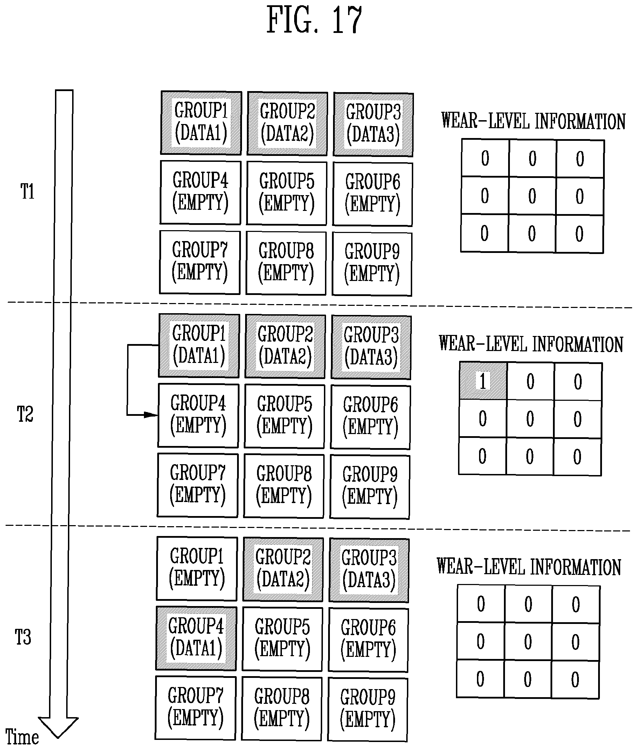

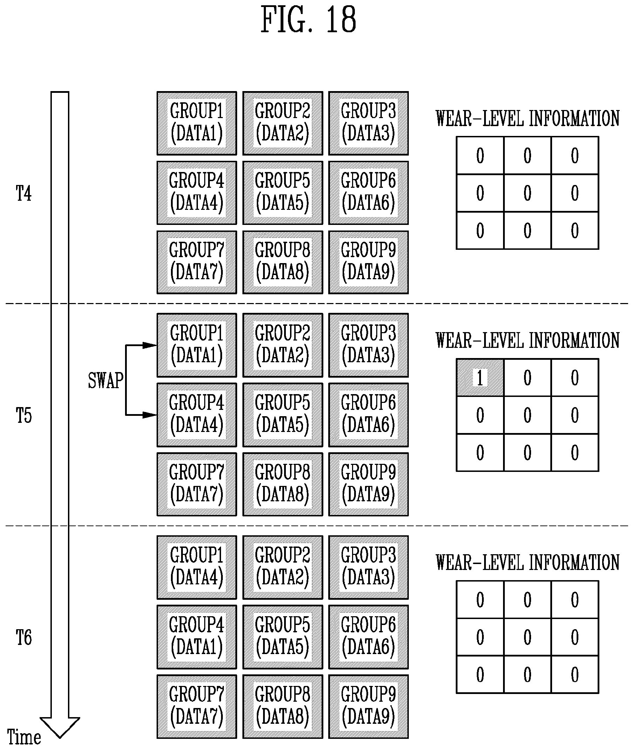

In various embodiments, the wear-level manager 250 may periodically monitor the wear-level information. That is, in order to prevent performance degradation due to the wear-leveling operation, whether to perform the wear-leveling operation may be determined by checking the wear-level information for each preset period rather than performing the wear-level operation each time the wear-level information exceeding the reference value is generated. A specific method of performing the wear-leveling operation is described in more detail with reference to FIGS. 17 and 18 to be described later.

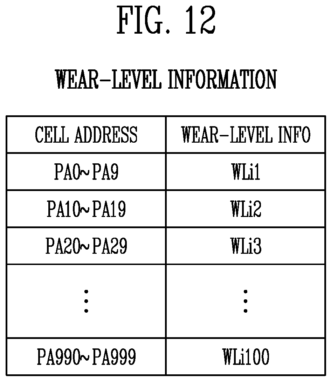

FIG. 12 is a diagram illustrating the wear-level information stored in the wear-level information storage 260 of FIG. 11 according to an embodiment of the present disclosure.

Referring to FIG. 12, the wear-level information may be managed for each physical address group of the memory cells. For example, the wear-level information of the 0-th to ninth physical addresses PA0 to PA9 may be first wear-level WLi1, and wear-level information of the tenth to nineteenth physical addresses PA10 to PA19 may be second wear-level WLi2. In the same method, the wear-level manager 250 described with reference to FIG. 11 may store the wear-level information of memory cells included in the memory device in the wear-level information storage 260.

In an embodiment, the wear-level information storage 260 may be implemented as a volatile memory device. For example, the wear-level information storage 260 may be implemented as a DRAM or an SRAM. In various embodiments, the wear-level information storage 260 may also be implemented as a non-volatile memory device.

In FIG. 12, the physical addresses of the memory cells are divided into 10 each, but this is only for convenience of description and does not limit the embodiment. In various embodiments, the wear-level information for 10 or less or 10 or more physical addresses of the memory cells may be managed.

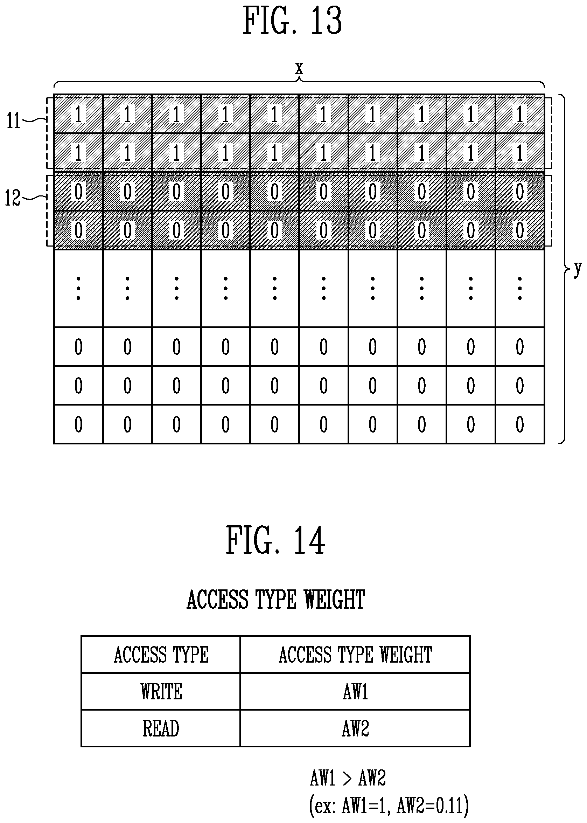

FIG. 13 is a diagram illustrating the wear-level information according to another embodiment of the present disclosure.

Referring to FIG. 13, the wear-level information may be in a bitmap data form. Specifically, the wear-level information may be managed in the bitmap data form indicating whether the calculated wear-level information exceeds a reference value.

In various embodiments, when managing the wear-level information with bitmap data, the wear-level information may be converted based on data after normalization by adjusting a range of the data.

In FIG. 13, wear-level information expressed in bits of the number of x columns and y rows is shown. One bit may indicate whether wear-level information of a plurality of memory cells exceeds the reference value. For example, one bit may correspond to memory cells that are accessed simultaneously when the write operation or the read operation is performed once.

Memory cells 11 in which bitmap data is stored as "1" may indicate that the wear-level information exceeds the reference value. Memory cells 12 in which bitmap data is stored as "0" may indicate that the wear-level information is less than or equal to the reference value. In various embodiments, memory cells in which bitmap data is stored as "0" may be memory cells included in an empty region in which data is not stored.

When the wear-level information on all memory cells is individually stored and managed, a large amount of memory capacity may be required. However, when the wear-level information is calculated then storing whether the wear-level information exceeded the reference value in a bitmap form, an amount of data to be stored may be reduced.

FIG. 14 is a diagram illustrating the access type weight according to an embodiment of the present disclosure.

Referring to FIG. 14, an access type may include a first access type weight AW1 corresponding to the write operation and a second access type weight AW2 corresponding to the read operation.

Values of the first access type weight AW1 and the second access type weight AW2 may be determined by an experiment performed in a manufacturing step or a test step of the memory device.

In general, a value of the first access type weight AW1 may be greater than that of the second access type weight AW2. For example, the first access type weight AW1 may be 1 and the second access type weight AW2 may be 0.11. This case means that a wear and tear degree of the memory cells may be greater in a case where the read operation is performed 10 times than a case where the write operation is performed once.

In FIG. 14, only the first access type weight AW1 corresponding to the write operation and the second access type weight AW2 corresponding to the read operation are shown. However, the access type weight may include more access type weights for each performed operation in addition to the write operation and the read operation.

The access type weight may be stored in the wear-level information storage 260 described with reference to FIG. 11.

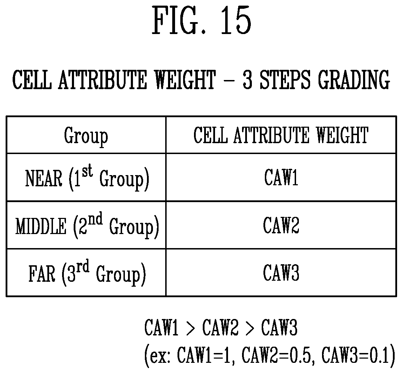

FIG. 15 is a diagram illustrating the cell attribute weight according to an embodiment of the present disclosure.

Referring to FIG. 15, the plurality of memory cells included in the memory device may be divided into the near group, the middle group, and the far group according to the path length. Alternatively, in various embodiments, the plurality of memory cells may be divided into the first group, the second group, and the third group according to the size of the line resistance. Since the path length of the memory cells belonging to the near group is shorter than that of the memory cells belonging to the middle group, a cycle endurance fail may be more likely to occur. Since the path length of the memory cells belonging to the middle group is shorter than that of the memory cells belonging to the far group, a cycle endurance fail may be more likely to occur. Therefore, the allowed number of cycles may be different according to which group the memory cells belong to.

Therefore, even though the same access operation is performed, a remaining lifespan of the memory cells belonging to the near group may remain substantially less. In order to consider this point, the wear-level manager 250 described with reference to FIG. 11 may reflect different weights according to a group to which target memory cells on which the access operation is performed belong (according to a cell attribute of the target memory cell).

For example, the cell attribute weight of the memory cells belonging to the near group may be a first cell attribute weight CAW1. The cell attribute weight of the memory cells belonging to the middle group may be a second cell attribute weight CAW2. The cell attribute weight of the memory cells belonging to the far group may be a third cell attribute weight CAW3.

Since the longer the path length of the memory cell, the cycle endurance characteristic is relatively better, the second cell attribute weight CAW2 may be less than the first cell attribute weight CAW1, and the third cell attribute weight CAW3 may be less than the second cell attribute weight CAW2. For example, the first cell attribute weight CAW1 may be 1, the second cell attribute weight CAW2 may be 0.5, and the third cell attribute weight CAW3 may be 0.1.

In various embodiments, since the line resistance of the memory cells belonging to the first group is less than that of the memory cells belonging to the second group, a cycle endurance fail may be more likely to occur. Since the line resistance of the memory cells belonging to the second group is less than that of the memory cells belonging to the third group, a cycle endurance fail may be more likely to occur. Therefore, the allowed number of cycles may vary according to which group the memory cells belong to.

Therefore, even though the same access operation is performed, a remaining lifespan of the memory cells belonging to the first group may remain substantially less. In order to consider this point, the wear-level manager 250 described with reference to FIG. 11 may reflect different weights according to a group to which target memory cells on which the access operation is performed belong (according to a cell attribute of the target memory cell).

For example, the cell attribute weight of the memory cells belonging to the first group may be a first cell attribute weight CAW1. The cell attribute weight of the memory cells belonging to the second group may be a second cell attribute weight CAW2. The cell attribute weight of the memory cells belonging to the third group may be a third cell attribute weight CAW3.

Since the longer the path length of the memory cell, the cycle endurance characteristic is relatively better, the second cell attribute weight CAW2 may be less than the first cell attribute weight CAW1, and the third cell attribute weight CAW3 may be less than the second cell attribute weight CAW2. For example, the first cell attribute weight CAW1 may be 1, the second cell attribute weight CAW2 may be 0.5, and the third cell attribute weight CAW3 may be 0.1.

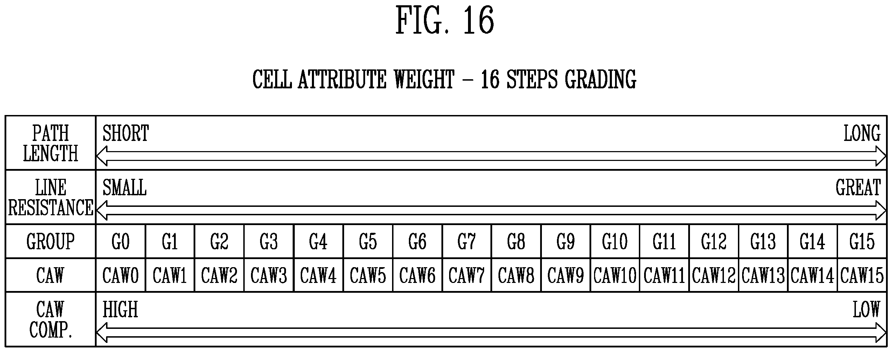

FIG. 16 is a diagram illustrating the cell attribute weight according to another embodiment of the present disclosure.

Referring to FIG. 16, differently from the embodiment of FIG. 15, a memory cell group may be divided into a 0-th group G0 to a fifteenth group G15. Cell attribute weights respectively corresponding to the 0-th group G0 to the fifteenth group G15 may be 0-th cell attribute weight CAW0 to fifteenth cell attribute weight CAW15.

A path length of memory cells belonging to the 0-th group G0 may be the shortest, and a path length of memory cells belonging to the fifteenth group G15 may be the longest. The path length may gradually become longer from the 0-th group G0 to the fifteenth group G15.

A size of a line resistance of the memory cells belonging to the 0-th group G0 may be the least, and a size of a line resistance of the memory cells belonging to the fifteenth group G15 may be the greatest. The size of the line resistance may increase from the 0-th group G0 to the fifteenth group G15.

The 0-th cell attribute weight CAW0 may have the largest value, and the fifteenth cell attribute weight CAW15 may have the smallest value. The size may gradually decrease from the 0-th cell attribute weight CAW0 to the fifteenth cell attribute weight CAW15.

In a case where the cell attribute weight according to the embodiment of FIG. 16 is applied, more accurate calculation of the wear-level information may be possible compared to a case where the cell attribute weight according to the embodiment of FIG. 15 is applied.

FIG. 17 is a diagram illustrating a wear-leveling operation according to an embodiment of the present disclosure.

In FIG. 17, the memory device includes memory cells divided into first to ninth groups (a total of nine groups) GROUP1 to GROUP9. Referring to FIG. 17, the wear-leveling operation may be performed in an order from T1 to T3.

In the T1 period, first data is stored in the first group, second data is stored in the second group, and third data is stored in the third group. Data may not be stored in the fourth to ninth groups of the memory cells. According to wear-level information in a form of 1-bit of bitmap data for each group in the T1 period, wear-level information of all groups may be "0", and a group having wear-level information exceeding the reference value may not be generated.

In the T2 period, according to wear-level information in a form of 1-bit of bitmap data for each group, wear-level information of the first group is changed to "1". This may mean that the wear-level information of the first group exceeds the reference value. In this case, the data storage device may perform the wear-leveling operation so that memory cells belonging to another group store data stored in the first group. At this time, the groups of which the wear-level information is "0" may be the second to ninth groups. Since data is stored in the second group and the third group, the data storage device may move data to memory cells belonging to one of the fourth group to ninth group in which data is empty.

In FIG. 17, the data storage device performs a wear-leveling operation of performing an operation of moving first data to memory cells belonging to the fourth group.

In the T3 period, when the first data moves to the memory cells belonging to the fourth group, the data storage device may reset the wear-level information of the first group to "0".

FIG. 18 is a diagram illustrating a wear-leveling operation according to another embodiment of the present disclosure.

In FIG. 18, differently from the embodiment of FIG. 17, the memory device includes memory cells divided into first to ninth groups (a total of nine groups) GROUP1 to GPOUP9, and first to ninth data DATA1 to DATA9 are stored in the first to ninth groups GROUP1 to GROUP9, respectively. Referring to FIG. 18, the wear-leveling operation may be performed in an order from T4 to T6.

In the T4 period, according to wear-level information in a form of 1-bit of bitmap data for each group in the T4 period, wear-level information of all groups may be "0" and a group having wear-level information exceeding the reference value is not generated.

In the T5 period, according to wear-level information in a form of 1-bit bitmap data for each group, wear-level information of the first group is changed to "1". This may mean that the wear-level information of the first group exceeds the reference value. In this case, the data storage device may perform the wear-leveling operation so that memory cells belonging to another group store data stored in the first group. In determining a target group to which the first data stored in the first group is to be moved, since a group in which data is empty does not exist, the data storage device may select one of the groups of which wear-level information is "0". For example, the data storage device may perform a wear-leveling operation of changing (swapping) the fourth data stored in the memory cells belonging to the fourth group and the first data stored in the memory cells belonging to the first group.

In the T6 period, the first data may be stored in the memory cells belonging to the fourth group, and the fourth data may be stored in the memory cells belonging to the first group. Thereafter, the data storage device may reset the wear-level information of the first group to "0".

The wear-leveling operation of FIGS. 17 and 18 describes a case in which the wear-leveling is performed when the wear-level information exceeds the reference value. However, in various embodiments, the wear-leveling operation may be performed at a preset period.

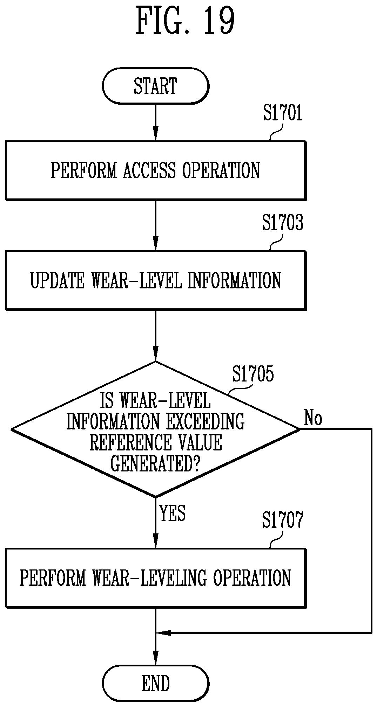

FIG. 19 is a flowchart illustrating an operation of a data storage device according to another embodiment of the present disclosure.

Referring to FIG. 19, in S1701, the data storage device may perform the access operation.

In S1703, the data storage device may update the wear-level information on the performed access operation. A specific method of updating the wear-level information is described in more detail with reference to FIG. 18.

In S1705, the data storage device may determine whether the wear-level information exceeding the reference value is generated. When it is determined that the wear-level information exceeding the reference value is generated (S1705, YES), an operation proceeds to S1707, and otherwise, the operation is ended.

In S1707, the data storage device may perform the wear-leveling operation so that data stored in a group corresponding to the wear-level information exceeding the reference value is stored in a memory cell belonging to another group.

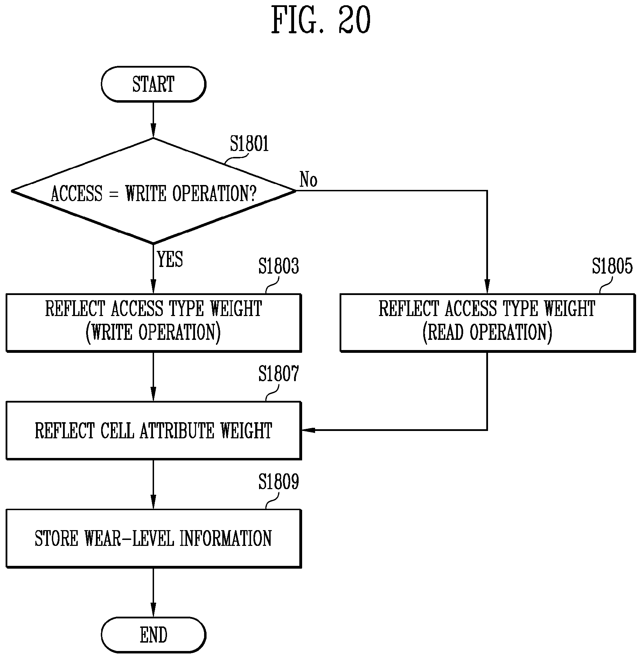

FIG. 20 is a flowchart illustrating a method of updating the wear-level information of FIG. 19 according to an embodiment of the present disclosure.

Referring to FIG. 20, in S1801, the data storage device may determine whether the performed access operation is the write operation. As a result of the determination, when the performed access operation is the write operation (S1801, YES), the method proceeds to S1803. When it is determined that the performed access operation is the read operation (S1801, No), the method proceeds to S1805.

In S1803, the data storage device may reflect an access type weight corresponding to the write operation as 1, which is the number of times the access operation is performed.

In S1805, the data storage device may reflect an access type weight corresponding to the read operation as 1, which is the number of times the access operation is performed. The access type weight corresponding to the read operation may be a value less than the access type weight corresponding to the write operation.

In S1807, the data storage device may reflect a cell attribute weight. Specifically, the data storage device may reflect a weight according to an attribute of a memory cell on which the access operation is performed.

In S1809, the data storage device may store (update) the generated wear-level information in the wear-level information storage.

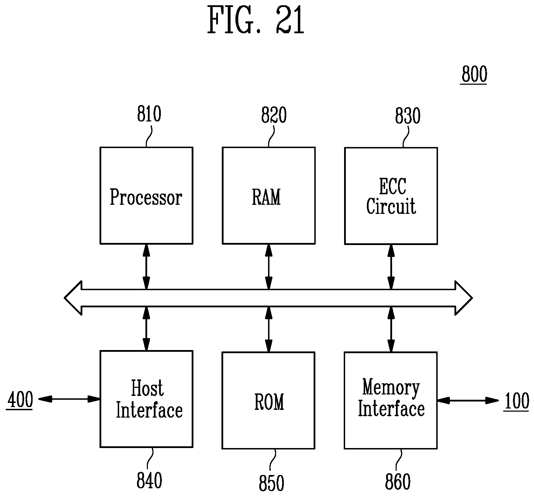

FIG. 21 is a diagram illustrating the controller of FIG. 1 according to another embodiment of the present disclosure.

Referring to FIG. 21, the memory controller 800 may include a processor 810, RAM 820, an error correction circuit 830, a host interface 840, a ROM 850, and a memory interface 860. The memory controller 800 may be the controller 200 described with reference to FIG. 1.

The processor 810 may control an overall operation of the memory controller 800. The RAM 820 may be used as a buffer memory, a cache memory, an operation memory, or the like of the memory controller 800. The operation processor 210, the address allocator 220, the data attribute determiner 230, and the wear-level manager 250 described with reference to FIGS. 7 and 11 may be stored in the ROM 850 or the RAM 820 as a form of software executed by the processor 810. In addition, the cell attribute information storage 230 and the wear-level information storage 260 may be included in the RAM 820.

The ROM 850 may store various pieces of information required for the memory controller 800 to operate in a form of firmware.

The memory controller 800 may communicate with an external device (for example, the host 400, an application processor, and the like) through the host interface 840.

The memory controller 800 may communicate with the memory device 100 through the memory interface 860. The memory controller 800 may transmit a command CMD, an address ADDR, a control signal CTRL, and the like to the memory device 100 and may receive data DATA through the memory interface 860.

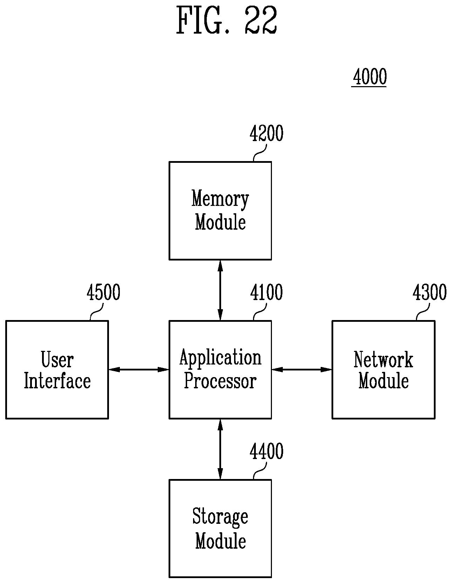

FIG. 22 is a block diagram illustrating a user system to which a data storage device according to an embodiment of the present disclosure is applied.

Referring to FIG. 22, the user system 4000 includes an application processor 4100, a memory module 4200, a network module 4300, a storage module 4400, and a user interface 4500.

The application processor 4100 may drive components, an operating system (OS), a user program, or the like included in the user system 4000. For example, the application processor 4100 may include controllers, interfaces, graphics engines, and the like that control the components included in the user system 4000. The application processor 4100 may be provided as a system-on-chip (SoC).

The memory module 4200 may operate as a main memory, an operation memory, a buffer memory, or a cache memory of the user system 4000. The memory module 4200 may include a volatile random access memory such as a DRAM, an SDRAM, a DDR SDRAM, a DDR2 SDRAM, a DDR3 SDRAM, an LPDDR SDARM, an LPDDR2 SDRAM, and an LPDDR3 SDRAM, or a nonvolatile random access memory, such as a PCM, a ReRAM, an MRAM, and an FRAM. For example, the application processor 4100 and memory module 4200 may be packaged based on a package on package (POP) and provided as one semiconductor package.

The network module 4300 may communicate with external devices. For example, the network module 4300 may support wireless communication such as code division multiple access (CDMA), global system for mobile communications (GSM), wideband CDMA (WCDMA), CDMA-2000, time division multiple access (TDMA), long term evolution, WiMAX, WLAN, UWB, Bluetooth, and Wi-Fi. For example, the network module 4300 may be included in the application processor 4100.

The storage module 4400 may store data. For example, the storage module 4400 may store data received from the application processor 4100. Alternatively, the storage module 4400 may transmit data stored in the storage module 4400 to the application processor 4100. For example, the storage module 4400 may be implemented with a nonvolatile semiconductor memory element such as a phase-change RAM (PRAM), a magnetic RAM (MRAM), a resistive RAM (RRAM), a NAND flash, a NOR flash, and a three-dimensional NAND flash. In an embodiment, the storage module 4400 may be the data storage device 50 described by FIG. 1. Alternatively, in various embodiments, the storage module 4400 may be provided as a removable storage device (removable drive), such as a memory card, and an external drive of the user system 4000.

For example, the storage module 4400 may include a plurality of nonvolatile memory devices, and the plurality of nonvolatile memory devices may operate identically to the memory device 100 described with reference to FIG. 1. The storage module 4400 may operate identically to the data storage device 50 described with reference to FIG. 1.

The user interface 4500 may include interfaces for inputting data or an instruction to the application processor 4100 or for outputting data to an external device. For example, the user interface 4500 may include user input interfaces such as a keyboard, a keypad, a button, a touch panel, a touch screen, a touch pad, a touch ball, a camera, a microphone, a gyroscope sensor, a vibration sensor, and a piezoelectric element. The user interface 4500 may include user output interfaces such as a liquid crystal display (LCD), an organic light emitting diode (OLED) display device, an active matrix OLED (AMOLED) display device, an LED, a speaker, and a monitor.

The inventive concept has been disclosed in conjunction with some embodiments as described above. Those skilled in the art will appreciate that various modifications, additions and substitutions are possible, without departing from the scope and spirit of the present disclosure. Accordingly, the embodiments disclosed in the present specification should be considered from not a restrictive standpoint but an illustrative standpoint. The scope of the inventive concept is not limited to the above descriptions but defined by the accompanying claims, and all distinctive features in the equivalent scope should be construed as being included in the inventive concept. Furthermore, the embodiments may be combined to form additional embodiments.

**Claims**

1. A data storage device comprising:

   a memory device including a plurality of memory cells disposed between word lines and bit lines, and a voltage generator configured to generate operation voltages and provide the operation voltages to the plurality of memory cells; and
   a controller configured to control the memory device to:

   divide the plurality of memory cells into a plurality of groups according to a line resistance from the voltage generator to each of the plurality of memory cells, and
   store data in memory cells included in a selected group among the plurality of groups according to an attribute of the data to be stored.

2. The data storage device of claim 1, wherein the controller includes a cell attribute information storage configured to store cell attribute information, which is information on a group to which each of the plurality of memory cells belong among the plurality of groups.

3. The data storage device of claim 2, wherein the memory device comprises:

   a word line controller configured to provide, to the word lines, a word line voltage among the operation voltages; and
   a bit line controller configured to provide, to the bit lines, a bit line voltage among the operation voltages.

4. The data storage device of claim 3, wherein a value of the line resistance reaching each of the plurality of memory cells increases as a path length increases, and
   the path length is determined as a sum of a length of a metal line from the voltage generator of the memory device to the word line controller and the bit line controller, a length of a word line connected from the word line controller to each of the plurality of memory cells, and a length of a bit line connected from the bit line controller to each of the plurality of memory cells.

5. The data storage device of claim 2, wherein the controller further comprises:

   an address allocator configured to allocate an address of memory cells selected to store the data according to the cell attribute information and the attribute of the data; and
   an operation processor configured to provide the memory device with a command instructing to store the data in the selected memory cells.

6. The data storage device of claim 5, wherein the plurality of groups include a first group, a second group, and a third group according to the line resistance.

7. The data storage device of claim 6, wherein a line resistance of memory cells belonging to the second group is greater than a line resistance of memory cells belonging to the first group and less than a line resistance of memory cells belonging to the third group.

8. The data storage device of claim 6, wherein the first group includes memory cells of which the line resistance belongs to a first range among the plurality of memory cells,

   the second group includes memory cells of which the line resistance belongs to a second range greater than the first range, among the plurality of memory cells, and
   the third group includes memory cells of which the line resistance belongs to a third range greater than the second range, among the plurality of memory cells.

9. The data storage device of claim 7, wherein the address allocator allocates, for the data, an address of the memory cells belonging to the first group when the attribute of the data is cold data that is accessed relatively less frequently.

10. The data storage device of claim 7, wherein the address allocator allocates, for the data, an address of memory cells belonging to the second group or the third group when the attribute of the data is hot data that is accessed relatively frequently.

11. The data storage device of claim 7, wherein the address allocator allocates, for the data, an address of the memory cells belonging to the first group when the attribute of the data is firmware data of the memory device.

12. The data storage device of claim 7, wherein the address allocator allocates, for the data, an address of the memory cells belonging to the second group or the third group when the attribute of the data is user data.

13. The data storage device of claim 1, wherein the plurality of memory cells includes an amorphous chalcogenide-based material.

14. A data storage device comprising:

a memory device including a plurality of groups each including a plurality of memory cells; and
a controller configured to control the memory device to:

store wear-level information determined according to the number of times an access operation on each of the plurality of groups is performed, a type of the access operation, and an attribute of each of the plurality of groups, and
perform a wear-leveling operation of moving data stored in memory cells belonging to a group selected based on the wear-level information, among the plurality of groups, to memory cells belonging to another group.

15. The data storage device of claim 14, wherein the controller comprises:

a wear-level manager configured to update wear-level information for a group in which memory cells on which the access operation is performed are included after an access operation is performed on the memory device; and
a wear-level information storage configured to store the wear-level information.

16. The data storage device of claim 15, wherein the wear-level information includes wear-level information corresponding to each of the plurality of groups.

17. The data storage device of claim 15, wherein the wear-level information includes bitmap data indicating whether wear-level information corresponding to each of the plurality of groups exceeds a reference value.

18. The data storage device of claim 17, wherein the wear-level manager moves data stored in a group having wear-level information exceeding the reference value among the plurality of groups to another group, based on the bitmap data.

19. The data storage device of claim 17, wherein the wear-level manager swaps data stored in a group having wear-level information exceeding the reference value among the plurality of groups with data stored in a group having wear-level information less than or equal to the reference value, based on the bitmap data.

20. The data storage device of claim 15, wherein the wear-level information storage stores information on an access type weight including a first access type weight corresponding to a write operation and a second access type weight corresponding to a read operation.

21. The data storage device of claim 20, wherein the memory device comprises:

a voltage generator configured to generate operation voltages and provide the operation voltages to the plurality of memory cells;
a word line controller configured to provide, to the word lines, a word line voltage among the operation voltages; and
a bit line controller configured to provide, to the bit lines, a bit line voltage among the operation voltages, and
wherein the plurality of groups are determined according to a line resistance from the voltage generator to each of the plurality of memory cells.

22. The data storage device of claim 21, wherein a value of the line resistance reaching each of the plurality of memory cells increases as a path length increases, and

the path length is determined as a sum of a length of a metal line from the voltage generator to the word line controller and the bit line controller, a length of a word line connected from the word line controller to each of the plurality of memory cells, and a length of a bit line connected from the bit line controller to each of the plurality of memory cells.

23. The data storage device of claim 22, wherein the wear-level information storage stores information on a cell attribute weight for each of the plurality of groups determined according to the size of the line resistance.

24. The data storage device of claim 23, wherein the information on the cell attribute weight includes a plurality of cell attribute weights increasing as the size of the line resistance decreases.

25. The data storage device of claim 23, wherein the wear-level manager calculates the wear-level information by reflecting the access type weight and the cell attribute weight in the number of times the access operation is performed.

26. The data storage device of claim 23, wherein the wear-level manager reflects the first access type weight in the number of times the access operation is performed when the access operation is a write operation, and reflects the second access type weight less than the first access type weight in the number of times the access operation is performed when the access operation is a read operation.

27. The data storage device of claim 23, wherein the wear-level manager updates the wear-level information by accumulating calculated wear-level information on previously stored wear-level information.

28. The data storage device of claim 14, wherein the plurality of memory cells include an amorphous chalcogenide-based material.

29. A data storage device comprising:

a plurality of memory groups each including a plurality of memory cells; and
a controller configured to move data stored in memory cells included one group among the plurality of memory groups to memory cells included in another memory group based on wear-level information reflecting a type of an operation performed on the plurality of memory cells and a weight corresponding to each of the plurality of memory groups.

FIG. 1

## FIG. 2

# FIG. 3

EP 4 651 138 A2

A) Write Bias (Set)

B) Write Bias (Reset)

C) Read Bias

# FIG. 4

FAR

WL

NEAR

| REGION 7 FAR | REGION 8 FAR | REGION 9 FAR |
| REGION 4 MIDDLE | REGION 5 MIDDLE | REGION 6 FAR |
| REGION 1 NEAR | REGION 2 MIDDLE | REGION 3 FAR |

X

BL

NEAR ⟶ FAR

# FIG. 5

| Path Length(PL)<br>= Metal Line + WL Length + BL Length to Cell | Group |
|---|---|
| $PL < D1$ | NEAR |
| $D1 \leq PL < D2$ | MIDDLE |
| $D2 \leq PL$ | FAR |

# FIG. 6

| Line Resistance(LR)<br>(From Voltage Generator to Cell) | Group |
|---|---|
| LR < R1 | $1^{st}$ Group |
| R1 ≤ LR < R2 | $2^{nd}$ Group |
| R2 ≤ LR | $3^{rd}$ Group |

# FIG. 7

# FIG. 8

## CELL ATTRIBUTE INFORMATION

| CELL ADDRESS | PATH LENGTH | Group |
|---|---|---|
| PA0~PA9 | PL1 | NEAR |
| PA10~PA19 | PL2 | MIDDLE |
| PA20~PA29 | PL3 | FAR |
| ⋮ | ⋮ | ⋮ |
| PA990~PA999 | PL100 | NEAR |

# FIG. 9

## CELL ATTRIBUTE INFORMATION

| CELL ADDRESS | LINE RESISTANCE | Group |
|---|---|---|
| PA0~PA9 | LR1 | 1st |
| PA10~PA19 | LR2 | 2nd |
| PA20~PA29 | LR3 | 3rd |
| ⋮ | ⋮ | ⋮ |
| PA990~PA999 | LR100 | 1st |

# FIG. 10

```
        ( START )
            │
            ▼
┌─────────────────────────┐  S801
│  PERFORM WRITE OPERATION │
└─────────────────────────┘
            │
            ▼
         ╱─────────╲  S803        YES
       ╱   DATA ATTRIBUTE ╲──────────────┐
       ╲ = HOT DATA?      ╱               │
         ╲─────────╱                      ▼
            │ No                 ┌──────────────────────────────────┐  S805
            ▼                    │ ALLOCATE MIDDLE GROUP (SECOND GROUP)│
┌─────────────────────────┐ S807 │ OR FAR GROUP (THIRD GROUP) ADDRESS │
│ ALLOCATE NEAR GROUP      │      └──────────────────────────────────┘
│ (FIRST GROUP) ADDRESS    │                        │
└─────────────────────────┘                        │
            │                                        │
            ▼                                        │
┌─────────────────────────┐  S809                    │
│ STORE DATA IN ALLOCATED ADDRESS │◄─────────────────┘
└─────────────────────────┘
            │
            ▼
        (  END  )
```

# FIG. 11

EP 4 651 138 A2

# FIG. 12

## WEAR-LEVEL INFORMATION

| CELL ADDRESS | WEAR-LEVEL INFO |
|---|---|
| PA0~PA9 | WLi1 |
| PA10~PA19 | WLi2 |
| PA20~PA29 | WLi3 |
| ⋮ | ⋮ |
| PA990~PA999 | WLi100 |

# FIG. 13

# FIG. 14

## ACCESS TYPE WEIGHT

| ACCESS TYPE | ACCESS TYPE WEIGHT |
|---|---|
| WRITE | AW1 |
| READ | AW2 |

AW1 > AW2
(ex: AW1=1, AW2=0.11)

# FIG. 15

## CELL ATTRIBUTE WEIGHT − 3 STEPS GRADING

| Group | CELL ATTRIBUTE WEIGHT |
|---|---|
| NEAR (1st Group) | CAW1 |
| MIDDLE (2nd Group) | CAW2 |
| FAR (3rd Group) | CAW3 |

CAW1 > CAW2 > CAW3
(ex: CAW1=1, CAW2=0.5, CAW3=0.1)

# FIG. 16

## CELL ATTRIBUTE WEIGHT – 16 STEPS GRADING

| PATH LENGTH | SHORT ⟵⟶ LONG | | | | | | | | | | | | | | | |
|---|---|---|---|---|---|---|---|---|---|---|---|---|---|---|---|---|
| LINE RESISTANCE | SMALL ⟵⟶ GREAT | | | | | | | | | | | | | | | |
| GROUP | G0 | G1 | G2 | G3 | G4 | G5 | G6 | G7 | G8 | G9 | G10 | G11 | G12 | G13 | G14 | G15 |
| CAW | CAW0 | CAW1 | CAW2 | CAW3 | CAW4 | CAW5 | CAW6 | CAW7 | CAW8 | CAW9 | CAW10 | CAW11 | CAW12 | CAW13 | CAW14 | CAW15 |
| CAW COMP. | HIGH ⟵⟶ LOW | | | | | | | | | | | | | | | |

EP 4 651 138 A2

# FIG. 17

# FIG. 18

T4

GROUP1 (DATA1) | GROUP2 (DATA2) | GROUP3 (DATA3)

GROUP4 (DATA4) | GROUP5 (DATA5) | GROUP6 (DATA6)

GROUP7 (DATA7) | GROUP8 (DATA8) | GROUP9 (DATA9)

WEAR-LEVEL INFORMATION

| 0 | 0 | 0 |
| 0 | 0 | 0 |
| 0 | 0 | 0 |

T5

SWAP

GROUP1 (DATA1) | GROUP2 (DATA2) | GROUP3 (DATA3)

GROUP4 (DATA4) | GROUP5 (DATA5) | GROUP6 (DATA6)

GROUP7 (DATA7) | GROUP8 (DATA8) | GROUP9 (DATA9)

WEAR-LEVEL INFORMATION

| 1 | 0 | 0 |
| 0 | 0 | 0 |
| 0 | 0 | 0 |

T6

GROUP1 (DATA4) | GROUP2 (DATA2) | GROUP3 (DATA3)

GROUP4 (DATA1) | GROUP5 (DATA5) | GROUP6 (DATA6)

GROUP7 (DATA7) | GROUP8 (DATA8) | GROUP9 (DATA9)

WEAR-LEVEL INFORMATION

| 0 | 0 | 0 |
| 0 | 0 | 0 |
| 0 | 0 | 0 |

Time

# FIG. 19

START

↓

S1701

PERFORM ACCESS OPERATION

↓

S1703

UPDATE WEAR-LEVEL INFORMATION

↓

S1705

IS WEAR-LEVEL INFORMATION EXCEEDING REFERENCE VALUE GENERATED? — No →

↓ YES

S1707

PERFORM WEAR-LEVELING OPERATION

↓

END

# FIG. 20

START

S1801

ACCESS = WRITE OPERATION?

No

YES

S1803

REFLECT ACCESS TYPE WEIGHT
(WRITE OPERATION)

S1805

REFLECT ACCESS TYPE WEIGHT
(READ OPERATION)

S1807

REFLECT CELL ATTRIBUTE WEIGHT

S1809

STORE WEAR-LEVEL INFORMATION

END

# FIG. 21

# FIG. 22

4000

4200

Memory
Module

4500

User
Interface

4100

Application
Processor

4300

Network
Module

4400

Storage
Module